# EUROPEAN PATENT SPECIFICATION

(11) **EP 0 361 759 B1**
(45) Date of publication and mention of the grant of the patent: **13.05.1998**
(21) Application number: 89309501.8
(22) Date of filing: 19.09.1989
(51) Int. Cl.: H01L 29/737, H01L 29/205, H01L 29/08

(54) **Heterostructure bipolar transistor**
Heterostrukturbipolartransistor
Transistor bipolaire à hétérostructure

(30) Priority: 28.09.1988 US 250790
(43) Date of publication of application: 04.04.1990
(73) Proprietor: AT&T Corp., New York, NY 10013-2412 (US)
(72) Inventor: Chen, Young-Kai, Berkeley Heights New Jersey 07922 (US); Levi, Anthony Frederic John, Summit New Jersey 07901 (US); Nottenburg, Richard Norman, New York New York 10014 (US); Panish, Morton, Springfield New Jersey 07081 (US)
(74) Representative: Watts, Christopher Malcolm Kelway, Dr.

(56) References cited:
- EP-A- 129 477
- EP-A- 226 383
- EP-A- 358 407
- APPLIED PHYSICS LETTERS. vol. 49, no. 17, 27 October 86, NEW YORK US pages 1112 - 1114; R.N.Nottenburg et.al.: "High gain InGaAas/InP heterostructure bipolar transistors grown by gas source molecular beam epitaxy."
- ELECTRONICS LETTERS. vol. 22, no. 21, October 1086, ENAGE GB pages 1143 - 1150; K.IMAMURA et al.: "InGaAs/InAlGaAs Hot-Electron Transistor with Current Gain of 15."
- IEEE ELECTRON DEVICE LETTERS. vol. 10, no. 6, June 1989, NEW YORK US pages 267 - 269; Y-K.CHEN et al.:: "Subpicosecond InP/InGaAs Heterostructure Bipolar Transistors."
- Applied Physics Letters 50(26), June 1997, 1915-7 (Najjar et al.)

## Description

### Field of the Invention

This application pertains to the field of active semiconductor devices. In particular, it pertains to heterostructure bipolar transistors in which at least some of the current is carried by hot electrons.

### Background of the Invention

It has been known for some time that a hot electron transistor could potentially be operated at frequencies in excess of those achievable with conventional (diffusive) transistors. See, for instance, T. E. Bell, IEEE Spectrum, February 1986, pp. 36-38. Various types of hot electron transistors (HET) have been proposed. This application is concerned with one particular class of such transistors, namely, hot electron heterojunction bipolar transistors (HBTs). For a brief review, see L. F. Eastman, ibid, pp. 42-45.

The flow of electrons from emitter to collector in a bipolar transistor is controlled by varying the emitter/base barrier potential by means of an applied voltage V_{eb}, and is also a function of an externally applied voltage V_{bc} between base and collector. Under normal operating conditions, V_{bc} reverse biases the base/collector junction. Electrons injected from the emitter into the base of a bipolar HET have energy substantially greater than the thermal energy of the ambient electrons in the base. These "hot" electrons ideally should traverse the base and collector depletion region without undergoing significant scattering, and enter the sea of conduction electrons in the collector contact region.

As will be readily understood by those skilled in the art, substantial difficulties have to be overcome before a device of this type can function as a practical HET. Among these is the difficulty of achieving substantial hot electron transport through the base and the depletion region of the collector.

EP-A-0226383, EP-A-0299686 and EP-A-0358407(having a publication date of 14.03.90) disclose means for achieving improved HETs. However, in view of the general desirability of improved characteristics such as larger DC current gain β (defined as collector current I_{c} divided by base current I_{b}) and high cut-off frequency f_{T}, means for achieving further improvements in HET characteristics would be of considerable significance.

In prior art HBTs the emitter stripe width is relatively large, typically at least about 1 µm and, to the best of our knowledge, has not been less than .6 µm even in a laboratory device that had quite low β (from the data reported it can be deduced to have been about 16; see N. Hayama et al, IEEE Electron Device Letters, Vol. EDL-8(5), May 1987, pp. 246-248). To the best of our knowledge, the prior art has not succeeded in making a HBT which combines at room temperature a large f_{T} (≥ 80 GHz) with a large (≥ 25) β and small (≤ 1 µm) emitter stripe width. This is to be contrasted with Si bipolar transistors in which high performance and stripe widths as small as 0.35 µm have been achieved (see S. Honaka et al, IEEE Transactions on Electronic Devices, Vol. ED-33, pp. 526-531, 1986). As is well known to those skilled in the art, narrow emitter stripe width is advantageous since it can, inter alia, result in lower power consumption at a constant current density (and thus make possible larger scale integration), or in increased speed at a constant current (and thus constant power).

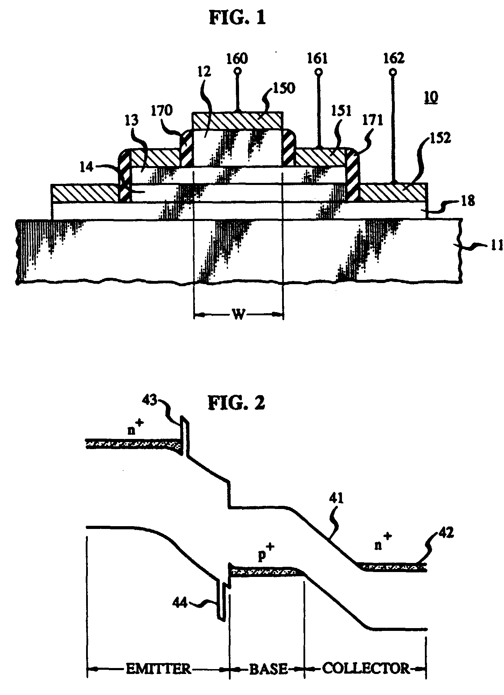

In a prior art (diffusive) bipolar transistor electrons are injected from the emitter stripe into the base, with the base typically being substantially wider than the emitter stripe (a bipolar transistor structure is schematically depicted in FIG. 1). The base region that underlies the emitter stripe is frequently referred to as the "intrinsic" base region, and the base regions that do not underlie the emitter stripe as the "extrinsic" base regions. It is to be noted that in this context "intrinsic" has nothing to do with the dopant concentration in the base region.

F.E. Najjar et al., in 'DC characterisation of the AlGaAs/GaAs tunneling emitter bipolar transistor', *Appl. Phy. Lett.,* **50**(26), 29 June 1987 1915-1917, disclose a bipolar transistor with a thin tunneling layer between the emitter and the base.

### Definitions

Electron transport in a crystal is herein defined to be "ballistic" if, in addition to its possible interaction with an accelerating electric field, the electron interacts substantially only with the static part of the periodic lattice potential. Electron transport thus may be ballistic even though the electrons undergo some small angle scattering and/or small energy change.

A conduction electron herein is considered to be a "hot" electron in a given semiconductor region if its energy E is substantially greater than the ambient thermal energy k_{B}T. Typically, E ≳ 8k_{B}T, where k_{B} is the Boltzmann constant, and T is the absolute temperature of the lattice.

A "hot electron" transistor (HET) is a transistor whose operative characteristics are in substantial part determined by the transport of hot electrons through the transit region of the transistor, with minimal scattering of the hot electrons in the transit region.

The "transit region" of a HET herein is that portion of the HET through which substantial hot electron transport takes place, or is intended to take place. For instance, in a bipolar transistor, the transit region consists of the base and the collector depletion region. In order to have the possibility of significant hot electron transport in a HET, the width of the transit region has to be less than the mean-free path of the hot electrons in the material.

The "ambient" charge carriers are those charge carriers (electrons or holes) that are essentially in thermal equilibrium with the lattice. For instance, in n-p-n HBTs the ambient charge carriers in the base are holes.

### Summary of the Invention

An HBT according to the invention is as set out in claim 1. Preferred forms of the invention are set out in dependent claims.

In an HBT as set out in claim 1 a semiconductor material comprised in the collector is selected to have Δ_{Γ-X}=E_{Γ-X}-E_{g}≥O, where E_{Γ-X} is the separation in energy between the Γ - minimum and the X-minimum in the conduction band of the material. Exemplarily, In_{0.53}Ga_{0.47}As, InAs and InP have Δ_{Γ-X} of about 0.4 eV, 1.45 eV, and 0.45 eV, respectively.

In at least some preferred devices the collector material also meets the criterion that Δ_{Γ-L}=E_{Γ-L}-E_{g}≥-0.2eV, where Δ_{Γ-L} is the separation in energy between the r - minimum and the L-minimum in the conduction band. Exemplarily, In_{0.53}Ga_{0.47}As, InAs, and InP have Δ_{Γ-L} of about -0.2 eV, 0.55 eV, and -0.2 eV, respectively.

Use of a semiconductor material that meets the first (preferably both) of the above criteria can result in a HBT in which a substantial fraction of the electron transport in the collector depletion region is ballistic. It can also result in a device whose cut-off frequency is substantially independent of V_{bc} over a voltage range that is compatible with current semiconductor technology. Exemplarily, for In_{0.53}Ga_{0.47}As this range of V_{bc} is between about 0 and about 0.4 volts, a convenient range for switching and other technologically significant applications.

In at least some preferred embodiments of the invention under normal operating conditions at least a significant fraction of the hot electrons injected into the base can traverse the base region without undergoing substantial scattering therein, the device has operating characteristics unattained by prior art HBTS (typically f_{T}≥ 80 GHz and β≥ 25, both at room temperature), and the emitter stripe has a width that is equal to or less than about 1µm. Differently stated, inventive HBTs can have an emitter stripe width W that is less than that of a diffusive HBT having the same β and f_{T}. If f_{T} of the inventive HBT is too large to be matched by any diffusive HBT then the diffusive comparison HBT is to have a f_{T} of at least 80 GHz.

The hot electrons injected into the base of an inventive transistor do not diffuse in the base but traverse the base more or less ballistically, spatially confined, in the form of a more or less well defined (diverging) beam of hot electrons. This mode of electron transport results in reduced likelihood of surface recombination, as manifested by substantial lateral scaling of inventive transistors. This makes possible a substantial reduction of the emitter stripe width without incurring the substantial decrease of β associated with prior art GaAs HBTs. In particularly preferred embodiments, the base region comprises a semiconductor material whose surface recombination velocity is substantially less than about 10⁵cm/sec, whereby surface recombination is still further reduced. Exemplarily, In_{0.53}Ga_{0.47}As is such a material.

HBTs with narrow emitter stripe according to the invention can have relatively low power dissipation for a given operating current density and thus are more suitable for large scale integration than prior art GaAs-based HBTs. Furthermore, due to low surface recombination, transistors according to the invention can have higher f_{T} than is obtainable in comparable prior art devices. Inventive transistors can find application in, for example, high speed, low power, digital and analog integrated circuits for high speed computers and fiber optic communication systems. Due to the improved lateral device scaling inventive HBTs can also advantageously be used in relatively high (> 10 GHi) and moderate (< 10 GHz) speed applications where small emitter stripe widths are required. Significantly, at least in some embodiments the inventive HBTs are well adapted to integration with optical and/or optoelectronic devices, especially such devices that are designed to operate at relatively long wavelengths, e.g., in the range 1.3-1.6 µm. This wavelength regime is currently preferred for fiber optical communications. Thus we contemplate apparatus and systems comprising one or more HBTs according to the invention and one or more optical or optoelectronic devices whose operating wavelength lies in the infrared part of the electromagnetic spectrum functionally integrated on or in a common semiconductor substrate, exemplarily an InP wafer or chip.

### Brief Description of the Drawings

FIG. 1 schematically depicts a device according to the invention; and
FIG. 2 schematically shows the relevant valence and conduction band edges in an exemplary device according to the invention.

The figures are not necessarily drawn to scale, nor are the relative proportions intended to be accurate.

### Detailed Description of Some Preferred Embodiments

FIG. 1 schematically depicts an exemplary HBT according to the invention. The transistor 10 comprises substrate 11, with collector contact region 18, collector depletion region 14, base region 13, and emitter region 12 being epitaxial with the respective adjacent regions and/or substrate. Typically the substrate is semi-insulating semiconductor material, collector and base region can (but need not) comprise the same semiconductor material as the substrate, and the emitter comprises semiconductor material that differs from that of the base. FIG. 1 also shows contact means 150, 151, and 152, and insulators 170 and 171 placed to prevent shorting. Indicated are also means 160, 161, and 162 for making electrical contact with the emitter, base, and collector regions, respectively. In many embodiments inventive HBTs have an elongate emitter region (the emitter "stripe") of width W. As will be appreciated by those skilled in the art, FIG. 1 is exemplary only and, for instance, HBTs having an inverted structure are also possible.

Those skilled in the art are familiar with techniques and processes that can be used to produce HBTs of the type relevant to this application. These processes comprise epitaxial growth processes such as molecular beam epitaxy or metal-organic chemical vapor deposition, ion implantation, rapid thermal annealing, lithography, and wet or dry etching.

We have discovered that, at least under some operating conditions, a significantly improved f_{T} can be achieved in HBTs which incorporate into the emitter two appropriately placed substantially undoped thin heteroepitaxial semiconductor layers (i.e., layers of a semiconductor other than the material of the bulk of the emitter), provided the material of the thin layers has the appropriate band structure.

The emitter charging time (τₑ) of a HBT defines the highest frequency at which the device can be operated, and is given by τₑ = RₑCₑ, where Rₑ and Cₑ are the emitter resistance and capacitance, respectively. As is well known, in conventional HBTs an increase in the doping level of the emitter decreases Rₑ but increases Cₑ and thus is not very effective in reducing τₑ.

We have found that incorporation of a relatively thin (exemplarily 1-10 nm, sufficient to prevent tunneling of holes from the base into the emitter under normal operating conditions) layer of semiconductor material of larger bandgap than the bulk of the emitter (with the offset being primarily in the valence band, with at most a small positive, preferably zero or negative, offset in the conduction band) into the emitter in close proximity to the base layer (e.g., 0-10 nm from the emitter/base interface) can result in improved majority carrier confinement in the base under high forward emitter junction bias.

We have also found that, to simultaneously achieve low Rₑ and Cₑ, an additional thin (e.g., 1-10 nm, the thickness chosen to permit tunneling through the layer, resulting in the desired Rₑ) epitaxial layer of semiconductor material (also having a wider bandgap than the emitter bulk material but having a band line-up such that the offset is primarily in the conduction band) should be incorporated into the emitter, with the spacing between the two heteroepitaxial layers typically being somewhat larger than the layer thicknesses, e.g., 10-50 nm. The spacing typically is chosen to result in the desired relatively low value of Cₑ. The bulk material between the heteroepitaxial layers advantageously is relatively lightly doped (e.g., about 10¹⁶ cm⁻³) to avoid space charging effects. Incorporation of the latter thin layer permits control of Cₑ independently of Rₑ, whereby τₑ can be significantly reduced. It is anticipated that this approach can result in very fast (cut-off frequency significantly above 100 GHz) HBTs, especially if the device is operated at high current densities (e.g., emitter current density greater than about 10⁴ A/cm²). At low current densities such devices however are likely to operate at somewhat lower speeds than optimized devices that do not have the additional layers in the emitter.

FIG. 2 schematically depicts the band diagram of an exemplary HBT comprising heteroepitaxial layers in the emitter. Exemplarily the emitter comprises InP, with epitaxial layer 43 (exemplarily 5 nm thick) consisting of In_{0.52}Al_{0.48}As, and epitaxial layer 44 (exemplarily also 5 nm thick, 5 nm set back from the emitter/base interface, 25 nm spacing between 43 and 44) consisting of In_{0.45}Al_{0.55}As. The base and the collector contact 42 comprise heavily doped (p- and n-type, respectively) In_{0.53}G_{0.47}As, with the collector depletion region consisting of the same material but being lightly doped or undopei The emitter contact region is heavily doped. As will be recognized by those skilled in the art, layers 43 and 44 are strained to control the valence band/conduction band offset, and the use of strained layers is currently thought to be an advantageous approach to the tailoring of the band structure of the material of the thin heteroepitaxial layers, and for tailoring of bandstructure in general.

## Claims

1. A heterostructure bipolar transistor comprising a collector region (14, 18), an emitter region (12), and a base region (13) intermediate and in contact with the emitter and collector regions, and further comprising means (160-162) for making electrical contact with the emitter, base, and collector regions, respectively; the transistor being of the type wherein, under normal operating conditions, hot electrons are injected into the base region from the emitter region,
the base region comprising p-type semiconductor material, and the collector region comprising a certain semiconductor material having E_{bw}-E_{g}≥0.6eV and E_{Γ-X}-E_{g}≥0, where E_{bw} and E_{g} are the conduction band width and the bandgap energy of said semiconductor material, and E_{Γ-X} is the separation in energy between a Γ-minimum and a X-minimum associated with said semiconductor material;
the emitter region comprising a first and a second semiconductor material, each of the first and second semiconductor materials having a valence band edge and a conduction band edge, the second material having a bandgap that is wider than the bandgap of the first material, the offset between the first and second material bandgaps being primarily in the valence band, with at most a small positive offset in the conduction band;
a thin layer (44) of the second material being epitaxial with the first material and situated at or close to the emitter region/base region interface and being nominally undoped, with the second material layer thickness preventing tunneling of holes from the base region into the emitter under normal operating conditions; and
the emitter region further comprises a thin nominally undoped layer (43) of a third semiconductor material epitaxial with the first material, the third material also having a bandgap that is wider than the bandgap of the first material, the offset between the first and third material bandgaps being primarily in the conduction band, the spacing between the second and third material layers being larger than the thickness of either of the layers, the second material layer (44) being spaced a distance in the range 0-10 nm from the emitter region/base region interface, the material between the second and third material layers being lightly doped n-type first material.

2. The transistor of claim 1, wherein the offset between the first and second material conduction band edge is zero or negative, and wherein said second material layer (44) is a stained layer.

3. The transistor of claim 1, wherein said certain semiconductor material is the base and collector material and has composition In_{0.53}Ga_{0.47}As.

4. The transistor of claim 1, wherein the second material layer (44) has a thickness in the range 1-10 nm.

5. An integrated circuit comprising a transistor according to claim 1 situated on a semiconductor substrate (11) and further comprising at least one other electronic or opto-electronic device electrically connected with said transistor and situated on or in said substrate.

## Revendications

1. Transistor bipolaire à hétérostructure comprenant une zone de collecteur (14, 18), une zone d'émetteur (12), et une zone de base (13) entre et en contact avec les zones d'émetteur et de collecteur, et comprenant en outre des moyens (160-162) pour établir un contact électrique avec les zones d'émetteur, de base et de collecteur, respectivement; le transistor étant du type dans lequel, en conditions de fonctionnement normal, des électrons chauds sont injectés dans la zone de base à partir de la zone d'émetteur,
la zone de base comprenant un corps semi-conducteur de type P, et la zone de collecteur comprenant un certain corps semi-conducteur ayant E_{bw} - E_{g} ≥ 0,6 eV et E_{Γ-X}-E_{g} ≥ 0 , où E_{bw} et E_{g} sont la largeur de la bande de conduction et l'énergie de bande interdite dudit corps semi-conducteur, et E_{Γ-X} est la séparation en énergie entre un Γ minimum et un X minimum associée audit corps semi-conducteur;
la zone d'émetteur comprenant un premier et un deuxième corps semi-conducteur, chacun des premier et deuxième corps semi-conducteurs ayant un bord de bande de valence et un bord de bande de conduction, le deuxième corps ayant une bande interdite qui est plus large que la bande interdite du premier corps, le décalage entre les bandes interdites des premier et deuxième corps étant essentiellement dans la bande de valence, avec au plus un petit décalage positif dans la bande de conduction;
une fine couche (44) du deuxième corps étant épitaxiée avec le premier corps et située au niveau ou près de l'interface zone d'émetteur/zone de base et étant nominalement non dopée, l'épaisseur de la couche de deuxième corps empêchant le franchissement par effet tunnel des trous depuis la zone de base dans l'émetteur dans des conditions de fonctionnement normal; et
la zone d'émetteur comprend en outre une fine couche nominalement non dopée (43) d'un troisième corps semi-conducteur épitaxié avec le premier corps, le troisième corps ayant aussi une bande interdite qui est plus large que la bande interdite du premier corps, le décalage entre les bandes interdites des premier et troisième corps étant essentiellement dans la bande de conduction, l'espacement entre les couches des deuxième et troisième corps étant plus large que l'épaisseur de l'une ou l'autre des couches, la couche de deuxième corps (44) étant espacée d'une distance de 0 à 10 nm de l'interface zone d'émetteur/zone de base, le corps entre les couches des deuxième et troisième corps étant un premier corps légèrement dopé de type N.

2. Transistor selon la revendication 1, dans lequel le décalage entre le bord de bande de conduction des premier et deuxième corps est nul ou négatif, et dans lequel ladite couche de deuxième corps (44) est une couche étirée.

3. Transistor selon la revendication 1, dans lequel ledit certain corps semi-conducteur est le corps de base et de collecteur et a une composition d'In_{0,53}Ga_{0,47}As.

4. Transistor selon la revendication 1, dans lequel la couche de deuxième corps (44) a une épaisseur dans la plage de 1 à 10 nm.

5. Circuit intégré comprenant un transistor selon la revendication 1, situé sur un substrat semi-conducteur (11) et comprenant en outre au moins un autre composant électronique ou optoélectronique électriquement connecté audit transistor et situé sur ou dans ledit substrat.

## Patentansprüche

1. Heterostruktur-Bipolartransistor mit einem Kollektorgebiet (14, 18), einem Emittergebiet (12) und einem Basisgebiet (13) zwischen und in Kontakt mit den Emitter- und Kollektorgebieten, und weiterhin mit Mitteln (160-162) zur Herstellung eines elektrischen Kontakts mit den Emitter-, Basis- bzw. Kollektorgebieten; wobei der Transistor des Typs ist, bei dem unter normalen Betriebsbedingungen heiße Elektronen vom Emittergebiet aus in das Basisgebiet injiziert werden,
wobei das Basisgebiet p-leitendes Halbleitermaterial umfaßt und das Kollektorgebiet ein gewisses Halbleitermaterial mit E_{bw}-E_{g} ≥ 0,6eV und E_{Γ-X}-E_{g}≥0 umfaßt, wobei E_{bw} und E_{g} die Leitungsbandbreite und die Bandabstandenergie des besagten Halbleitermaterials sind und E_{Γ-X} die energiemäßige Trennung zwischen einem mit dem besagten Halbleitermaterial verbundenen r-Mindestwert und einem X-Mindestwert ist;
wobei das Emittergebiet ein erstes und ein zweites Halbleitermaterial umfaßt, die jeweils eine Valenzbandkante und eine Leitungsbandkante aufweisen, wobei das zweite Material einen breiteren Bandabstand als der Bandabstand des ersten Materials aufweist, wobei die Versetzung zwischen den Bandabständen des ersten und zweiten Materials hauptsächlich im Valenzband liegt, mit höchstens einer kleinen positiven Versetzung im Leitungsband;
wobei eine dünne Schicht (44) des zweiten Materials epitaxial zum ersten Material liegt und bei dem oder der oder nahe an dem oder der Emittergebiet/Basisgebietgrenzfläche liegt und nominell undotiert ist, wobei die Schichtstärke des zweiten Materials Durchtunnelung von Löchern vom Basisgebiet in den Emitter unter normalen Betriebsbedingungen verhindert; und
wobei das Emittergebiet weiterhin eine dünnnominell undotierte Schicht (43) eines dritten Halbleitermaterials epitaxial zum ersten Material umfaßt, wobei das dritte Material ebenfalls einen breiteren Bandabstand als der Bandabstand des ersten Materials aufweist, wobei die Versetzung zwischen den Bandabständen des ersten und dritten Materials hauptsächlich im Leitungsband liegen, wobei der Abstand zwischen den Schichten des zweiten und dritten Materials größer als die Stärke einer der Schichten ist, wobei die Schicht (44) des zweiten Materials in einem Abstand im Bereich von 0-10 nm von dem oder der Emittergebiet/Basisgebietgrenzfläche beabstandet ist, wobei das Material zwischen den Schichten des zweiten und dritten Materials leicht dotiertes n-leitendes erstes Material ist.

2. Transistor nach Anspruch 1, wobei die Versetzung zwischen der Leitungsbandkante des ersten und zweiten Materials null oder negativ ist und wobei die besagte Schicht (44) des zweiten Materials eine gespannte Schicht ist.

3. Transistor nach Anspruch 1, wobei das besagte gewisse Halbleitermaterial das Basis- und Kollektormaterial ist und die Zusammensetzung In_{0,53}Ga_{0,47}As aufweist.

4. Transistor nach Anspruch 1, wobei die Schicht (44) des zweiten Materials eine Stärke im Bereich 1-10 nm aufweist.

5. Integrierte Schaltung mit einem auf einem Halbleitersubstrat (11) befindlichen Transistor nach Anspruch 1 und weiterhin mit mindestens einem anderen elektronischen oder optoelektronischen Bauelement, das elektrisch mit dem besagten Transistor verbunden ist und sich auf oder im besagten Substrat befindet.
